# EUROPEAN PATENT APPLICATION

(11) **EP 3 444 952 A1**
(43) Date of publication of application: **20.02.2019**
(21) Application number: 18187694.7
(22) Date of filing: 07.08.2018
(51) Int. Cl.: H03M 7/30, H03M 7/40

(54) **DATA COMPRESSION APPARATUS, DATA DECOMPRESSION APPARATUS, DATA COMPRESSION PROGRAM, DATA DECOMPRESSION PROGRAM, DATA COMPRESSION METHOD, AND DATA DECOMPRESSION METHOD**

(30) Priority: 14.08.2017 JP 2017156328
(71) Applicant: FUJITSU LIMITED, Kanagawa 211-8588 (JP)
(72) Inventor: Itani, Noriko, Kanagawa, 211-8588 (JP)
(74) Representative: Hoffmann Eitle

(57) **Abstract**

An apparatus includes a processor that detects a match sequence that matches with a preceding partial sequence in input data, a relative position of the match sequence with respect to the partial sequence, and a match length which is a length of the match sequence; retains the relative position encoded lastly; selects one of a plurality of encoding formats based on closeness indicated by the relative position, the encoding formats being set such that the number of bits to be allocated to the relative position varies among the encoding formats; and encodes the input data by arranging codes in byte unit and omitting, depending on the encoding format selected, the relative position when the relative position is the same as the relative position encoded lastly and retained by the processor.

## Description

### FIELD

The embodiments discussed herein are related to a data compression apparatus, a data decompression apparatus, a data compression program, a data decompression program, a data compression method, and a data decompression method.

### BACKGROUND

The performance of a lossless data compression technique, which is one of data compression techniques, is measured based on a compression ratio (compression ratio = (size of compressed data)/(size of original data)), a compression speed, and a decompression speed. Examples of conventionally-known lossless data compression methods include the LZ77 method and the LZ4 method.

The LZ77 method reduces the amount of data as follows. When data inputted to a data compression apparatus has a partial sequence (also referred to as a match sequence) that matches with a preceding partial sequence (also referred to as an earlier partial sequence), the match sequence is replaced with a match length and a match position. The match length is the length of the match sequence, and the match position is the relative position of the match sequence with respect to the earlier partial sequence with which the match sequence matches. In this method, if input data includes a non-match sequence that does not match with any earlier partial sequences, the compressed data includes the non-match sequence and a non-match length, which is the length of the non-match sequence.

The LZ4 method is in the LZ77 family, and encodes input data by allocating predetermined fixed numbers of bits to the match length, the match position, and the non-match length. The fixed numbers of bits are arranged in byte unit. In the LZ4 method, the non-match sequence constitutes part of compressed data as it is. The LZ4 offers one of the fastest decompression speeds in the LZ77 family.

To improve the speed of data reading, not only high decompression speed, but also reduction in the amount of data (the number of codes) to be decompressed are desired. The desired decompression speed may lead to a reading time, for example, two or three times that of the speed of reading uncompressed data.

Related techniques are disclosed in, for example, Japanese Laid-open Patent Publication No. 2005-286371.

### SUMMARY

### TECHNICAL PROBLEM

The LZ4 method encodes input data by allocating a match position a fixed number of bytes, namely two bytes. In such a case, the codes consist mostly of bits allocated to match positions except for incompressible non-match sequences, and the compression ratio decreases accordingly.

If Huffman coding or the like is used to make the number of codes for a match position variable, the compression ratio improves, but may cause problems such as the decompression speed becoming slower than the speed of reading in a storage medium or the like.

In one object of the invention, it is to reduce the number of codes without decreasing the decompression speed.

### SOUTION TO PROBLEM

In one aspect of the invention, an apparatus includes a processor that detects a match sequence that matches with a preceding partial sequence in input data, a relative position of the match sequence with respect to the partial sequence, and a match length which is a length of the match sequence; retains the relative position encoded lastly; selects one of a plurality of encoding formats based on closeness indicated by the relative position, the encoding formats being set such that the number of bits to be allocated to the relative position varies among the encoding formats; and encodes the input data by arranging codes in byte unit and omitting, depending on the encoding format selected, the relative position when the relative position is the same as the relative position encoded lastly and retained by the processor.

### ADVANTAGEOUS EFFECTS OF INVENTION

It is to reduce the number of codes without decreasing the decompression speed.

### BRIEF DESCRIPTION OF DRAWINGS

FIG. 1 is a diagram illustrating an example of original data to be compressed and an example of compressed data obtained using the LZ77 method;
FIG. 2 is a diagram illustrating a data compression method according to a first embodiment;
FIG. 3 is a diagram of functional blocks of a data compression apparatus according to first, second, and third embodiments;
FIG. 4A is a diagram illustrating a procedure of conventional data compression processing, and FIG. 4B is a diagram illustrating a procedure of processing performed by the data compression apparatus according to the first, second, and third embodiments;
FIG. 5 is a diagram of functional blocks of a data decompression apparatus according to the first, second, and third embodiments;
FIG. 6A is a diagram illustrating a procedure of conventional data decompression processing, and FIG. 6B is a diagram illustrating a procedure of data decompression apparatus according to the first, second, and third embodiments;
FIG. 7 is a diagram illustrating examples of hardware configurations of the data compression apparatus and the data decompression apparatus according to the first, second, and third embodiments;
FIGs. 8A, 8B, and 8C are diagrams illustrating a data compression method according to the second embodiment; and
FIGs. 9A, 9B, and 9C are diagrams illustrating a data compression method according to the third embodiment.

### DESCRIPTION OF EMBODIMENTS

### First Embodiment

A data compression method according to the present embodiment is based on the LZ77 method and further focuses on the following points. First, data such as tabular data tends to contain the same partial sequence repeatedly. Secondly, in such data, match sequences tend to have the same match position in a row. Thirdly, since the same partial sequences are often repeated closely in such data, the non-match length, the non-match sequence, the match position, and the like are often representable with a small number of bits. Based on these points, the present embodiment reduces the number of bytes or bits to which to allocate information on a match position upon compression, to thereby reduce the data amount of the compressed data to improve the compression ratio. Further, in the present embodiment, to maintain a high decompression speed, the number of bits to which to allocate a partial sequence to be encoded is predetermined uniquely, and the bits are arranged in byte unit.

The data compression apparatus according to the present embodiment retains information on a match position (which information is also referred to as a match position). Then, when a new match sequence is detected in input data and when the match position of the new match sequence is the same as the preceding match position being retained (in other words, when the input data has the same match positions in a row), the data compression apparatus encodes the input data with omission of the match position of the new match sequence. Further, the data compression apparatus changes codes depending on whether the match position indicates a close position or a far position. This is described specifically below.

The data compression apparatus selects one of encoding formats having different numbers of bits (bytes) to allocate to a match position and performs data compression processing based on the encoding format selected. In the present embodiment, there are four encoding formats. Upon detecting a match sequence in input data, the data compression apparatus lumps together data that ends with the match sequence, and encodes the data. The lumped data is also referred to as sub-data. The data compression apparatus selects one of the encoding formats depending on whether the match position of the match sequence in the sub-data indicates a far position or a close position, and encodes the sub-data based on the encoding format selected.

The data compression apparatus adds identification bits to compressed sub-data. To the identification bits, encoding format information is allocated, the encoding format information being information for identifying the encoding format used to encode the sub-data. More specifically, for encoding of four consecutive sets of sub-data, the data compression apparatus according to the present embodiment prepends, to the four sets of sub-data lumped together, four sets of identification bits which correspond to the respective four sets of sub-data and are arranged according to the order of the four sets of sub-data. In the present embodiment, the determination bits are two bits for each sub-data. Hence, the four sets of sub-data have one byte long information prepended thereto as the sum of four sets of determination bits for them. As long as the sum of the determination bits is in byte unit, the disclosure is not limited to the above-described mode. For example, with two sets of sub-data lumped together, two sets of four-bit-long identification bits may be prepended to these two sets of sub-data.

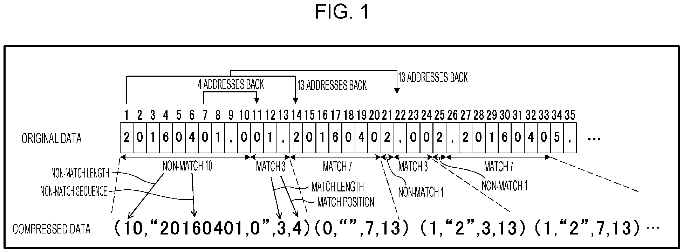

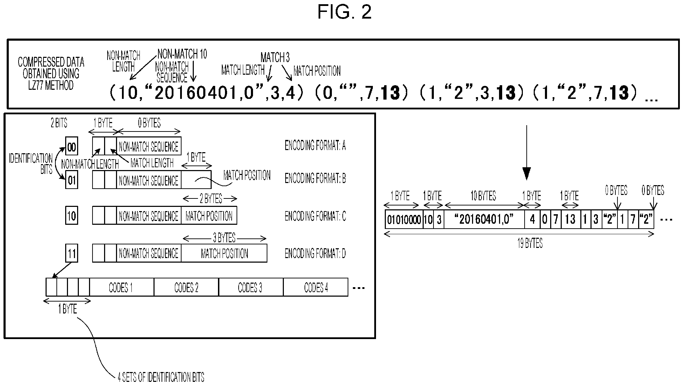

A specific description is given using FIGs. 1 and 2. FIG. 1 is a diagram illustrating an example of original data to be compressed and an example of compressed data obtained by the LZ77 method. The original data to be compressed is, as illustrated in FIG. 1,
"20160401,001,20160402,002,20160405,". Each of these numbers is allocated one byte. First, the first match sequence in this data is the partial sequence "01," from address 11 to address 13, which matches with the partial sequence "01," from address 7 to address 9, which is four addresses back. Thus, the first sub-data is from address 1 to address 13.

Note that in the present embodiment, a partial sequence whose match length is two bytes or less is not handled as a match sequence. This is because encoding a match sequence with a match length of two bytes or less by replacing the match sequence with a match length or with a match length and a match position often does not decrease the number of codes.

Here, with reference to FIG. 1, a description is given of how the sub-data "20160401,001," from address 1 to address 13 is compressed using the LZ77 method. In the compressed data of this sub-data, the partial sequence from address 11 to address 13, which is a match sequence, is replaced by 3 indicating the match length from address 11 to address 13. The compressed data also contains 4 as a match position because 4 is the relative position of address 11, which is the first address of the match sequence, with respect to address 7, which is the first address of the preceding partial sequence "01,". The compressed data also contains, in the sub-data "20160401,001,",: "20160401,0" as a non-match sequence from address 1 to address 10; and 10 as the non-match length of this non-match sequence.

Since the sub-data "2016040" from address 14 to address 20 is the same as the partial sequence 13 addresses back, the compressed data contains 13 as a match position and 7 as the match length of the match sequence "2016040". Since this sub-data does not have a non-match sequence, the compressed data of this sub-data contains 0 as a non-match length, and the non-match sequence part is blank. Hereinafter, sub-data after compression is also referred to as compressed sub-data or codes. Note that codes mean not only compressed sub-data, but also any other compressed data.

FIG. 2 is a diagram illustrating a data compression method according to the present embodiment. The original data used in FIG. 1 is also used here. The square at the lower left of FIG. 2 depicts encoding formats in the present embodiment. The present embodiment has four encoding formats (encoding formats A, B, C, and D). One of these encoding formats is selected for each sub-data, and compressed sub-data is generated based on the encoding format selected. In the present embodiment, four sets of compressed sub-data are lumped together as described earlier. Then, sets of identification bits that indicate the encoding formats selected for the generation of the respective four sets of compressed sub-data are arranged according to the order of four sets of compressed sub-data and collectively prepended to the compressed sub-data sets.

As illustrated in the lower left part of FIG. 2, a non-match length and a match length are allocated to the first one byte of each set of codes. Although the bits allocated to the non-match length are located before the bits allocated to the match length in FIG. 2, this is merely an example, and the order of these is not limited to this. In this example, four bits are allocated to each of the non-match length and the match length. In this example, the maximum value of a non-match length in bit representation is "1110". Thus, when bits allocated to a non-match length is "1111", this is not a bit representation of a non-match length. Instead, "1111" indicates that a new byte is added to be allocated to the non-match length. This new byte is added immediately after the byte to which the non-match length and the match length are allocated. The non-match length is expressed in bit representation by this additional byte and the original four bits.

Similarly, the maximum value of a match length in bit representation is "1110", and bits "1111" indicate that a new byte is further added to be allocated to the match length. This additional byte is added immediately after the byte to which the non-match length and the match length are allocated or after an additional byte which may be allocated to the non-match length.

A data compression apparatus 1 according to the present embodiment encodes original data by, as described earlier, replacing a match sequence whose match length is three bytes or more with a match length or with a match length and a match position. Thus, an encoded match length is a bit representation of an actual match length minus 3. Note that a match sequence with a match length of two bytes or less is not detected as a match sequence in the detection processing to be described later.

A non-match sequence is next assigned to each set of codes. Note that the number of bits or bytes allocated to the non-match sequence depends on the non-match length.

Next, a detailed description is given of encoding formats. The encoding format A is selected when the current codes have the same match position as the previous codes. For example, in the compressed data obtained using the LZ77 method depicted in the square at the top of FIG. 2, the match positions in the compressed sub-data sets indicated in the second, third, and fourth parentheses from the left are all 13. Then, the encoding format A is selected to compress the third and fourth sets of sub-data in the original data. In the encoding format A, zero bits are allocated to the match position, and the codes do not include the match position. The identification bits for the encoding format A are "00" in the example illustrated in FIG. 2.

The encoding format B is selected when the match position of the current codes is different from that of the previous codes and is a number representable with one byte (an integer 2⁸-1=255 or less). In this encoding format, one byte is allocated to the match position. The identification bits for the encoding format B are "01" in the example illustrated in FIG. 2.

The encoding format C is selected when the match position of the current codes is different from that of the previous codes and is a number which is not representable with one byte but representable with two bytes (an integer of 2¹⁶-1 or less). In this encoding format, two bytes are allocated to the match position. The identification bits for the encoding format C are "10" in the example illustrated in FIG. 2.

The encoding format D is selected when the match position of the current codes is different from that of the previous codes and is a number which is not representable with two bytes but representable with three bytes (an integer of 2²⁴-1 or less). In this encoding format, three bytes are allocated to the match position. The identification bits for the encoding format D are "11" in the example illustrated in FIG. 2.

The total number of bits in each set of codes including the two bits for the identification bits and excluding the non-match sequence is, for the encoding format A for example, 10 bits (2 (identification bits) +4 (non-match length) +4 (match length) +0 (match position) =10). Similarly, the total number of bits is 18 in the encoding format B, 26 in the encoding format C, and 34 in the encoding format D.

The lower right part of FIG. 2 depicts compressed data obtained when the data compression apparatus according to the present embodiment compresses the original data illustrated in FIG. 1. Here, the data depicted at the lower right part of FIG. 2 is described using the compressed data obtained using the LZ77 method illustrated in the upper part of FIG. 2. First, the first compressed sub-data from the left in the compressed data obtained by the LZ77 method has a non-match length of 10 and a match length of 3. Thus, the head of the first codes (codes 1) in the lower right part of FIG. 2 is a combination of a bit representation of 10 and a bit representation of 3 after subtraction of 3, the bit representations being arranged in the order mentioned.

For the codes 1, 10 bytes are allocated for the non-match sequence "20160401,0". Since the match position in the codes 1 is 4, which is representable with one byte, the encoding format B is selected. Thus, the identification bits for the codes 1 are "01".

Similarly, the fourth compressed sub-data from the left in the compressed data obtained by the LZ77 method has a match position of 13. This match position is the same as the match position 13 of the immediately preceding, third compressed sub-data from the left in the compressed data. Hence, the encoding format A is selected for the generation of the fourth codes (codes 4) in the lower right part of FIG. 2. Thus, zero bytes are allocated to the match position for the generation of the codes 4.

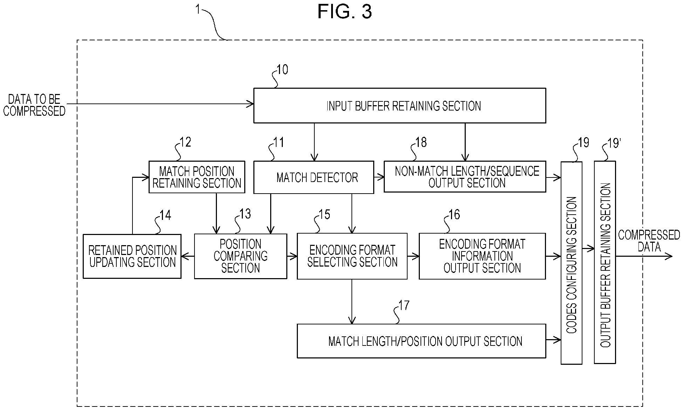

FIG. 3 is a functional block diagram of the data compression apparatus 1 according to the present embodiment. The data compression apparatus 1 includes an input buffer retaining section 10, a match detecting section 11, a match position retaining section 12, a position comparing section 13, a retained position updating section 14, an encoding format selecting section 15, and the like. The data compression apparatus 1 further includes an encoding format information output section 16, a match length/position output section 17, a non-match length/sequence output section 18, a codes configuring section 19, and an output buffer retaining section 19'. Note that a combination of the encoding format information output section 16, the match length/position output section 17, and the codes configuring section 19 or a combination of the encoding format information output section 16, the match length/position output section 17, the non-match length/sequence output section 18, and the codes configuring section 19 is also referred to as an encoding section.

The input buffer retaining section 10, the match detecting section 11, and the non-match length/sequence output section 18 are connected to one another. The match detecting section 11, the position comparing section 13, and the encoding format selecting section 15 are connected to one another. The match position retaining section 12, the position comparing section 13, and the retained position updating section 14 are connected to one another. The encoding format selecting section 15 is connected to the encoding format information output section 16 and the match length/position output section 17. The encoding format information output section 16, the match length/position output section 17, and the non-match length/sequence output section 18 are connected to the codes configuring section 19. The codes configuring section 19 is connected to the output buffer retaining section 19'. Note that connection relations illustrated herein are an example, and the sections may be connected differently.

The data compression apparatus 1 receives data to be compressed via the input buffer retaining section 10. The input buffer retaining section 10 retains the input data to be compressed.

The match detecting section 11 detects a match sequence in the data to be compressed, and also detects the match position and match length of the detected match sequence. The match detecting section 11 detects these by sequentially reading the data to be compressed from the beginning. Upon every detection of a match sequence in the data to be compressed, the match detecting section 11 generates sub-data containing the match sequence. Note that the match detecting section 11 may acquire the whole data to be compressed, divide it into one or more sets of sub-data, and process these sets of sub-data one by one.

The match position retaining section 12 retains the match position used for the encoding of the next previous sub-data (also referred to as the next previous match position, the immediately preceding match position, or the last match position).

The position comparing section 13 compares the match position retained by the match position retaining section 12 with the match position of the match sequence in the sub-data being currently processed for encoding (compression) (such sub-data is also referred to as the current sub-data, and a match position in the current sub-data is also referred to as a current match position).

When the two match positions compared by the position comparing section 13 are different from each other, the retained position updating section 14 updates the match position retained by the match position retaining section 12 to the current match position. When the current match position is the same as the last match position, the retained position updating section 14 does not update the match position retained by the match position retaining section 12. However, the present disclosure is not limited to this, and when the current match position is the same as the last match position, the retained position updating section 14 may update the match position retained by the match position retaining section 12 to the same value.

The encoding format selecting section 15 acquires a match length, a match position, and the like from the match detecting section 11. Further, the encoding format selecting section 15 acquires a processing result from the position comparing section 13, and if the current match position is the same as the match position retained by the match position retaining section 12, selects the encoding format A. Otherwise, the encoding format selecting section 15 selects one of the encoding formats B, C, and D depending on whether the current match position indicates a close position or a far position. The encoding format selecting section 15 outputs encoding format information corresponding to the selected encoding format to the encoding format information output section 16. Note that the encoding format selecting section 15 may acquire the match length, the match position, and the like from the position comparing section 13.

The encoding format information output section 16 encodes the encoding format information from the encoding format selecting section 15, and outputs this to the codes configuring section 19. After every encoding of a single piece of encoding format information, the encoding format information output section 16 outputs the encoded encoding format information to the codes configuring section 19. However, the disclosure is not limited to this, and the encoding format information output section 16 may output, for example, four pieces of encoding format information collectively to the codes configuring section 19 after the four pieces of encoding format information are encoded.

The match length/position output section 17 acquires, from the encoding format selecting section 15, the match length of, or the match length and match position of, the match sequence and the encoding format information in the current sub-data. The match length/position output section 17 encodes the match position of the match sequence in the current sub-data according to the encoding format, encodes the match length of the match sequence, and outputs these encoded sets of data to the codes configuring section 19.

The non-match length/sequence output section 18 acquires sub-data and a match sequence and the like in the sub-data sequentially, one set at a time, from the match detecting section 11. Then, the non-match length/sequence output section 18 generates a non-match sequence based on the sub-data and the match sequence. Alternatively, the non-match length/sequence output section 18 may acquire data to be compressed from the input buffer retaining section 10 and a match sequence and the like from the match detecting section 11. Then, the non-match length/sequence output section 18 may generate sub-data for each match sequence in the data to be compressed, and generate a non-match sequence by omitting the match sequence from the sub-data.

The non-match length/sequence output section 18 finds the non-match length of the non-match sequence generated. The non-match length/sequence output section 18 finds the non-match length by sequentially counting up the generated non-match sequence. Note that the disclosure is not limited to this. For example, the non-match length/sequence output section 18 may acquire data to be compressed from the input buffer retaining section 10 and a match sequence and the like from the match detecting section 11, and acquire the data to be compressed in byte unit with the non-match length/sequence output section 18 synchronizing with the match detecting section 11. In this case, the non-match length/sequence output section 18 is notified when the match detecting section 11 detects a match sequence. Until thus notified, the non-match length/sequence output section 18 may find a non-match length by counting the data to be compressed from the input buffer retaining section 10. Alternatively, the match detecting section 11 may count a non-match length until it detects a match sequence, and output the non-match length to the non-match length/sequence output section 18 upon detecting a match sequence. The non-match length/sequence output section 18 encodes the non-match sequence and the non-match length thereof and outputs them to the codes configuring section 19.

The codes configuring section 19 rearranges and lumps together the codes from the encoding format information output section 16, the match length/position output section 17, and the non-match length/sequence output section 18 as illustrated in the lower right part of FIG. 2, and outputs the lumped codes as compressed data. For example, this rearrangement is performed as follow. The codes configuring section 19 acquires codes for the same sub-data from the encoding format information output section 16, the match length/position output section 17, and the non-match length/sequence output section 18. The codes configuring section 19 places the codes from the non-match length/sequence output section 18 before the codes from the match length/position output section 17. Then, the codes configuring section 19 performs the same processing on the next sub-data from the match length/position output section 17 and the non-match length/sequence output section 18. The codes configuring section 19 then places the codes obtained by this processing after the codes obtained by the previous processing (the processed codes from the match length/position output section 17 and the non-match length/sequence output section 18). The codes configuring section 19 of the present embodiment arranges codes from the encoding format information output section 16 (information on the identification bits), in the order they are inputted. The codes configuring section 19 of the present embodiment repeats the above processing until codes for four sets of sub-data are inputted. Then, the codes configuring section 19 of the present embodiment prepends the combination of the four sets of identification bits to the four combinations of the arranged codes from the match length/position output section 17 and the non-match length/sequence output section 18.

Alternatively, for each compressed sub-data, the codes configuring section 19 may arrange the codes from the above-described sections in the order of the codes from the encoding format information output section 16, the codes from the non-match length/sequence output section 18, and the codes from the match length/position output section 17.

The output buffer retaining section 19' retains and outputs compressed sub-data outputted from the codes configuring section 19.

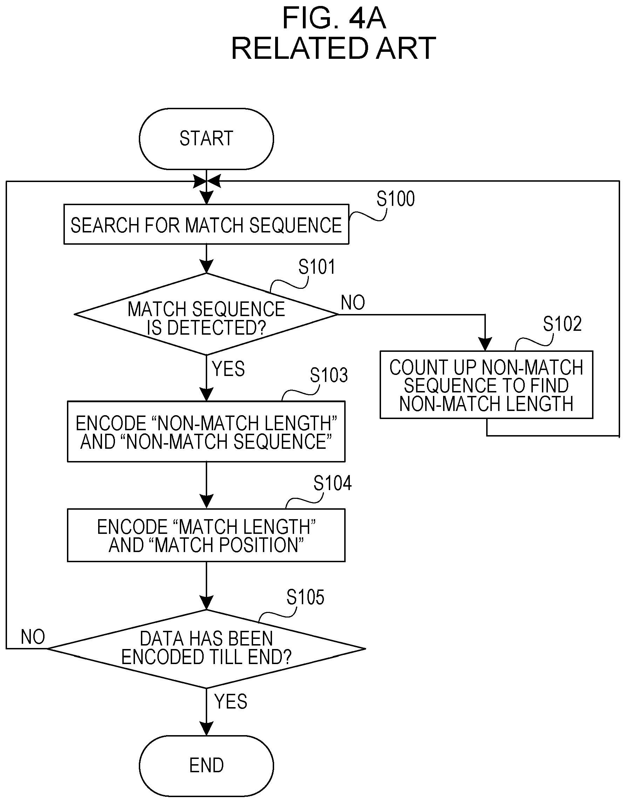

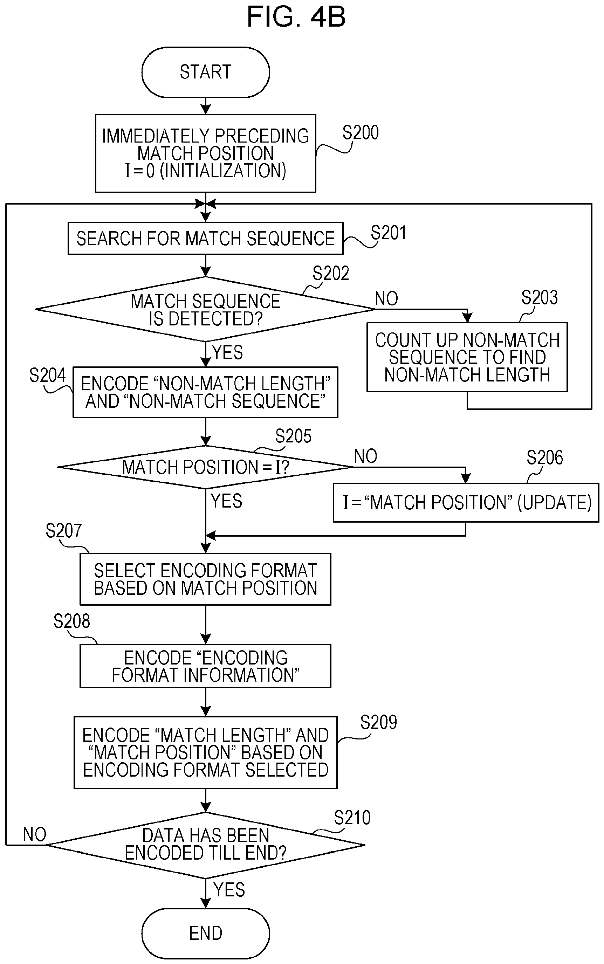

FIGs. 4A and 4B are diagrams illustrating procedures of processing performed by a conventional data compression apparatus and processing performed by the data compression apparatus according to the present embodiment. FIG. 4A illustrates the procedure of conventional data compression processing, and FIG. 4B illustrates the procedure of processing performed by the data compression apparatus according to the present embodiment.

First, as a comparison with the compression processing according to the present embodiment, a brief description is given of conventional data compression processing. Upon receiving data to be compressed, a conventional data compression apparatus searches for a match sequence that matches with any preceding partial sequence in the data (Step S100). While detecting no match sequence (Step S101: NO), the convention data compression apparatus counts up a non-match sequence to find the non-match length thereof (Step S102), and further searches for a match sequence (Step S100). When detecting a match sequence (Step S101: YES), the convention data compression apparatus encodes the non-match length and the non-match sequence (Step S103), and encodes the match length and the match position (Step S104). The convention data compression apparatus ends the processing after encoding the end of the data to be compressed (Step S105: YES), and otherwise (Step S105: NO), searches an unencoded part of the data to be compressed for a match sequence (Step S100).

Next, using the flowchart illustrated in FIG. 4B, a description is given of processing performed by the data compression apparatus 1 according to the present embodiment. First, as initialization, the match position retaining section 12 stores 0 in a parameter I for the immediately preceding match position and retains the parameter I (Step S200). This processing to store 0 in I is performed by the retained position updating section 14 in this example, but may be performed by the match position retaining section 12 instead.

Next, the match detecting section 11 searches data to be compressed inputted from the input buffer retaining section 10 for a match sequence that matches with any preceding partial sequence (Step S201).

While detecting no match sequence (Step S202: NO), the match detecting section 11 or the non-match length/sequence output section 18 counts up a non-match sequence to find the non-match length thereof (Step S203). Note that the initial value of a non-match length is 0.

When a match sequence is detected (Step S202: YES), the non-match length/sequence output section 18 encodes the non-match length and the non-match sequence (Step S204).

The position comparing section 13 compares the match position acquired from the match detecting section 11 with the value of I retained by the match position retaining section 12 (Step S205).

When the current match position is different from the value of I (Step S205: NO), the position comparing section 13 outputs this comparison result and the current match position to the retained position updating section 14. The retained position updating section 14 updates the value of I retained by the match position retaining section 12 to the current match position acquired from the position comparing section 13 (Step S206).

When the current match position is the same as the value of I (Step S205: YES), the position comparing section 13 outputs this comparison result to the retained position updating section 14. Receiving this comparison result, the retained position updating section 14 does not update the value of I retained by the match position retaining section 12. Note that the disclosure is not limited to this, and when the current match position is the same as the value of I, the position comparing section 13 may not output the comparison result to the retained position updating section 14, so that the retained position updating section 14 does not update I. Alternatively, when the current match position is the same as the value of I, the position comparing section 13 may output the comparison result and the current match position to the retained position updating section 14, and in response, the retained position updating section 14 may or may not update I to the same value.

Based on the comparison result from the position comparing section 13 or based on the comparison result from the position comparing section 13 and the match position from the match detecting section 11, the encoding format selecting section 15 selects an encoding format (Step S207). The encoding format selecting section 15 outputs encoding format information corresponding to the selected encoding format to the encoding format information output section 16.

The encoding format information output section 16 encodes the encoding format information (Step S208). Based on the encoding format information from the encoding format selecting section 15, the match length/position output section 17 encodes the match length and the match position acquired from the match detecting section 11 via the encoding format selecting section 15 (Step S209). Note that if the encoding format information in the encoding format selecting section 15 corresponds to the encoding format A, the match length/position output section 17 may acquire only the encoding format information and the match length from the encoding format selecting section 15 and not acquire the match position.

When encoding of the data to be compressed is completed, such as when the match detecting section 11 has searched the data to be compressed till the end of it (Step S210: YES), the processing by the data compression apparatus 1 according to the present embodiment ends. When encoding of the data to be compressed is not completed (Step S210: NO), the match detecting section 11 searches for a match sequence (Step S201).

In the procedure of the processing by the data compression apparatus 1 according to the present embodiment, Step S204 may be performed before or after the processing in Step S207 or in parallel with the processing in Steps S205 and S206. Further, the processing in Step S207 and the processing in S208 may be performed in reverse order or in parallel. If the processing in Step S204 is performed before or after the processing in Step S207, the processing in Step S204 may be performed in parallel with either one of Steps S207 and S208, and Steps S207 and S208 may be reversed in order.

The processing by the data compression apparatus 1 according to the present embodiment additionally includes Steps S200 and S205 to S208, compared to the conventional processing. Further, the encoding in Step S209 uses encoding format information, and this is another point different from the conventional processing.

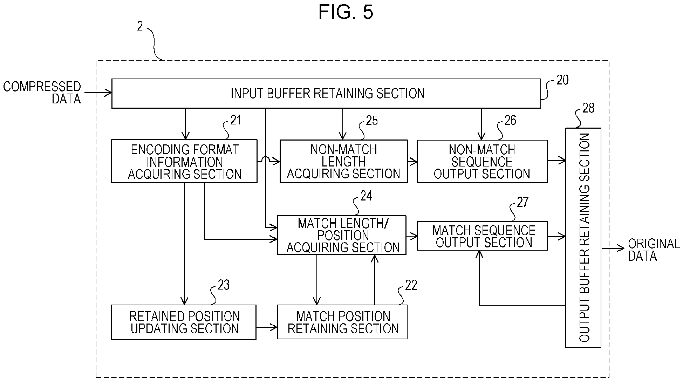

Next, a description is given of a data decompression apparatus that decompresses compressed data obtained by the data compression apparatus 1. FIG. 5 is a diagram of the functional blocks of a data decompression apparatus 2 according to the present embodiment. The data decompression apparatus 2 includes an input buffer retaining section 20, an encoding format information acquiring section 21, a match position retaining section 22, a retained position updating section 23, a match length/position acquiring section 24, a non-match length acquiring section 25, and the like. The data decompression apparatus 2 further includes a non-match sequence output section 26, a match sequence output section 27, an output buffer retaining section 28, and the like. The input buffer retaining section 20, the encoding format information acquiring section 21, and the match length/position acquiring section 24 are connected to one another. The input buffer retaining section 20, the non-match length acquiring section 25, and the non-match sequence output section 26 are connected to one another. The encoding format information acquiring section 21 is connected to the retained position updating section 23 and the non-match length acquiring section 25. The match position retaining section 22 is connected to the retained position updating section 23 and the match length/position acquiring section 24. The match length/position acquiring section 24 is connected to the match sequence output section 27. The non-match sequence output section 26 and the match sequence output section 27 are connected to the output buffer retaining section 28. Note that the connection relations are not limited to the above.

The input buffer retaining section 20 receives input of compressed data and retains the compressed data. The encoding format information acquiring section 21 acquires information such as encoding format information from the compressed data retained by the input buffer retaining section 20 (the encoding format information is a bit representation of encoding format information and may also be referred to as encoding format information hereinbelow). In this example, the encoding format information acquiring section 21 acquires the encoding format information from the first byte prepended to four sets of compressed sub-data, and also acquires the match positions in the respective sets of compressed sub-data in turn. Note that the disclosure is not limited to this, and the encoding format information acquiring section 21 may acquire a pair of encoding format information and a match position for each of the four sets of compressed sub-data. Moreover, if the compressed data retained by the input buffer retaining section 20 is such that each set of compressed sub-data has its corresponding piece of encoding format information prepended thereto, the encoding format information acquiring section 21 may acquire pairs of the compressed sub-data and encoding format information one by one. Further, the encoding format information acquiring section 21 may acquire a match length and the like besides the match position.

The match position retaining section 22 retains a match position. According to the encoding format information acquired from the encoding format information acquiring section 21, the retained position updating section 23 updates the match position retained by the match position retaining section 22. In this example, when the encoding format information in bit representation is "01", "10", or "11", the retained position updating section 23 updates the match position retained by the match position retaining section 22. When the encoding format information is "00" in bit representation, the retained position updating section 23 does not update the match position retained by the match position retaining section 22. Note that the disclosure is not limited to this, and when the encoding format information is "00" in bit representation, the retained position updating section 23 may update the match position retained by the match position retaining section 22 to the same value. Further, when the match position retained by the match position retaining section 22 is not updated, or more specifically, when the encoding format information is "00" in bit representation, the encoding format information acquiring section 21 may output nothing to the retained position updating section 23.

The retained position updating section 23 sequentially acquires encoding format information and a match position in its corresponding compressed sub-data from the encoding format information acquiring section 21.

When the current encoding format information is "01", "10", or "11" in bit representation, the retained position updating section 23 updates the match position retained by the match position retaining section 22 to the current match position acquired from the encoding format information acquiring section 21.

The match length/position acquiring section 24 acquires encoding format information from the input buffer retaining section 20 or the encoding format information acquiring section 21. Then, based on the encoding format information thus acquired, the match length/position acquiring section 24 acquires the match position and the match length of the current compressed sub-data from the input buffer retaining section 20 (or the encoding format information acquiring section 21) or from the match position retaining section 22. When the current encoding format information is other than "00", the match length/position acquiring section 24 acquires the match position of the current compressed sub-data from the input buffer retaining section 20 (or the encoding format information acquiring section 21). When the current encoding format information is "00", the match length/position acquiring section 24 acquires the match position from the match position retaining section 22. The match length/position acquiring section 24 acquires the match length in the current compressed sub-data from the input buffer retaining section 20 (or the encoding format information acquiring section 21).

In order for the encoding format information acquiring section 21 and the match length/position acquiring section 24 and the like to handle information on the same compressed sub-data, the encoding format information acquiring section 21 may notify the match length/position acquiring section 24 every time data is read from the input buffer retaining section 20. Thus notified, the match length/position acquiring section 24 may acquire each combination of a match length and a match position in compression sub-data in turn from the input buffer retaining section 20. Alternatively, the encoding format information acquiring section 21 may acquire a match length and a match position from the input buffer retaining section 20 (when the bit representation of the encoding format information is other than "00"), and output the match length and match position of each compressed sub-data to the match length/position acquiring section 24.

The non-match length acquiring section 25 acquires a non-match length of the current compressed sub-data from the input buffer retaining section 20 (or the encoding format information acquiring section 21). The non-match length acquiring section 25 may acquire a non-match sequence from the input buffer retaining section 20 (or the encoding format information acquiring section 21). In order for the non-match length acquiring section 25 to target the current compressed sub-data, the non-match length acquiring section 25 may be, for example, notified by the encoding format information acquiring section 21 like the match length/position acquiring section 24 described above. The non-match length acquiring section 25 decompresses the non-match length acquired.

The non-match sequence output section 26 acquires the non-match length from the non-match length acquiring section 25, and acquires a non-match sequence of the non-match length from the non-match length acquiring section 25 or the input buffer retaining section 20. Then, the non-match sequence output section 26 makes a copy of the acquired non-match sequence and outputs the copy to the output buffer retaining section 28. Note that when the non-match sequence output section 26 acquires the non-match sequence from the input buffer retaining section 20, the non-match sequence output section 26 may be, for example, notified by the non-match length acquiring section 25 to make the compressed sub-data containing the non-match sequence coincide with the current compressed sub-data.

The match sequence output section 27 acquires the match length and the match position of the current compressed sub-data from the match length/position acquiring section 24, and decompresses a match sequence of the match length at the match position. In this event, the match sequence output section 27 acquires (copies), from data decompressed earlier and retained in the output buffer retaining section 28, a match sequence of the acquired match length at the acquired match position. Then, the match sequence output section 27 outputs the copy of the match sequence to the output buffer retaining section 28. Note that the match sequence output section 27 may output the copy after every output from the non-match sequence output section 26 to the output buffer retaining section 28.

The output buffer retaining section 28 retains an output from the non-match sequence output section 26 and an output from the match sequence output section 27, and outputs a combination of these outputs as original data.

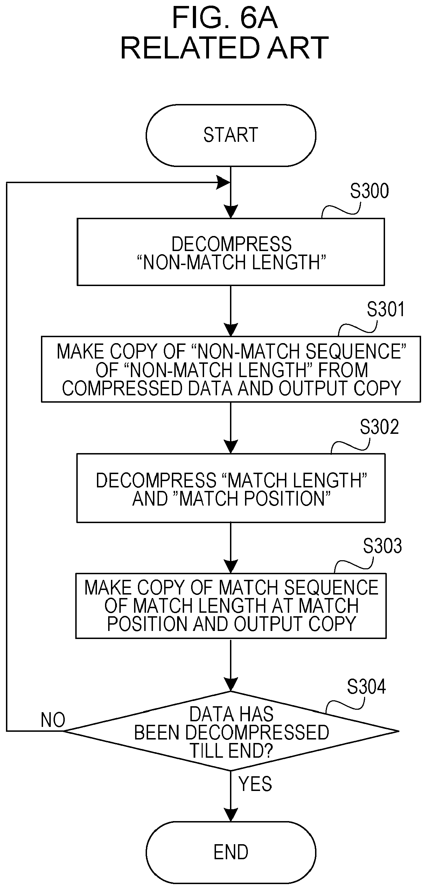

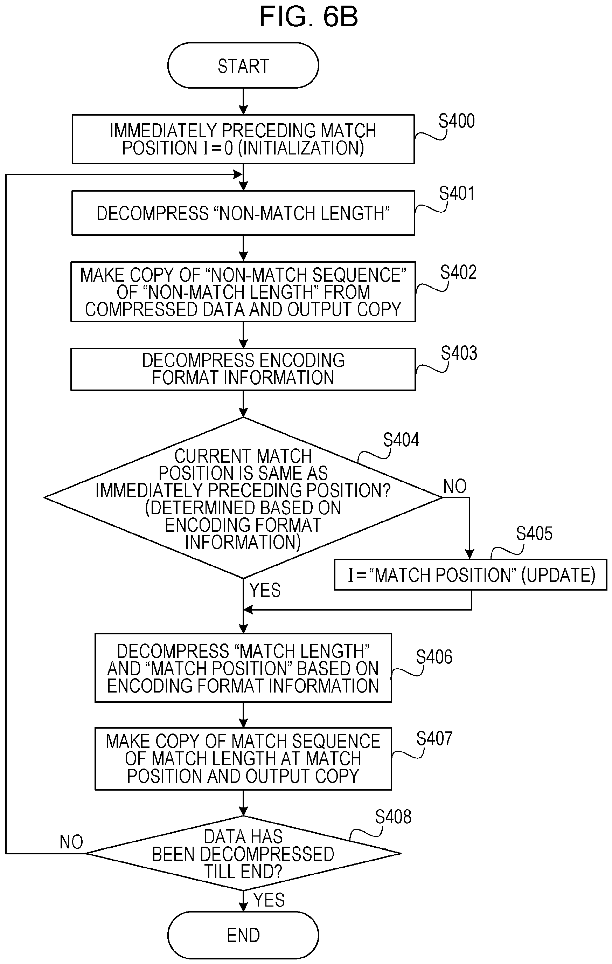

FIGs. 6A and 6B are diagrams illustrating procedures of processing performed by a conventional data decompression apparatus and processing performed by the data decompression apparatus according to the present embodiment, respectively. First, with reference to FIG. 6A, a brief description is given of conventional data decompression processing to illustrate how the data decompression processing according to the present disclosure is different from the conventional data decompression processing.

The conventional data decompression apparatus decompresses a non-match length (Step S300), makes a copy of a non-match sequence of the decompressed non-match length from the compressed data, and outputs the copy to the output buffer (Step S301). The conventional data decompression apparatus further decompresses a match length and a match position from the compressed data (Step S302), reads and copies a match sequence of the match length from the output buffer, and outputs the match sequence thereby decompressed to the output buffer (Step S303). The compressed data is sequentially decompressed in this way. The above processing is repeated until the end of the compressed data is decompressed (Step S304: NO), and is ended when the end of the compressed data is decompressed (Step S304: YES).

FIG. 6B illustrates the procedure of processing performed by the data decompression apparatus 2 according to the present embodiment. Prior to or in response to input of new compressed data to the input buffer retaining section 20, the retained position updating section 23 of the data decompression apparatus 2 initializes the match position retained by the match position retaining section 22. Specifically, the retained position updating section 23 stores 0 in a match position parameter I (Step S400). "I" is a parameter that points to the immediately preceding match position regarding sequentially-processed compressed sub-data.

The non-match length acquiring section 25 acquires a non-match length of the current compressed sub-data from the input buffer retaining section 20 (or the encoding format information acquiring section 21), and decompresses the non-match length (Step S401). The non-match sequence output section 26 acquires a non-match sequence of the acquired non-match length from the input buffer retaining section 20 or the non-match length acquiring section 25, and outputs a copy of the non-match sequence to the output buffer retaining section 28 (Step S402).

The encoding format information acquiring section 21 acquires encoding format information for the current compressed sub-data from the input buffer retaining section 20 and decompresses the encoding format information (Step S403).

The encoding format information acquiring section 21 outputs the decompressed encoding format information to the retained position updating section 23. When the bit representation of the encoding format information is other than "00", the encoding format information acquiring section 21 outputs the match position in the current compressed sub-data to the retained position updating section 23. Note that when the bit representation of the encoding format information is "00", the encoding format information acquiring section 21 may or may not output the match position in the current compressed sub-data to the retained position updating section 23.

Based on the encoding format information, the retained position updating section 23 determines whether the immediately preceding match position retained is the same as the current match position (Step S404). When the immediately preceding match position and the current match position are different from each other (Step S404: NO), the retained position updating section 23 updates I in the match position retaining section 22 to the current match position (Step S405). When the immediately preceding match position and the current match position are the same (Step S404: YES), I is not updated.

Depending on the encoding format, the match length/position acquiring section 24 acquires a match position from the input buffer retaining section 20 (or the encoding format information acquiring section 21), or from the match position retaining section 22. The match length/position acquiring section 24 also acquires a match length from the input buffer retaining section 20 (or the encoding format information acquiring section 21) and decompresses the match position and the match length (Step S406). The match sequence output section 27 acquires the match position and the match length from the match length/position acquiring section 24, acquires a match sequence of the match length at the match position from the output buffer retaining section 28, and outputs a copy of the match sequence to the output buffer retaining section 28 (Step S407).

When, for example, it is determined that the encoding format information acquiring section 21 and the like have yet to acquire the last set of data in the compressed data retained by the input buffer retaining section 20 (Step S408: NO), the processing by the data decompression apparatus 2 proceeds back to Step S401. When, for example, it is determined the last set of data in the compressed data has been processed (Step S408: YES), the data decompression apparatus 2 ends the processing.

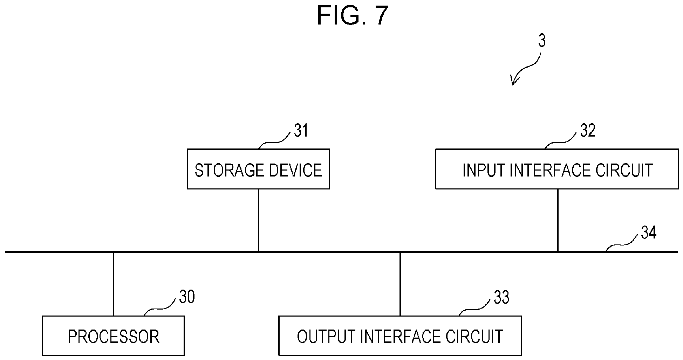

FIG. 7 is a diagram illustrating an example of hardware configurations of the data compression apparatus 1 and the data decompression apparatus 2 according to the present embodiment. Herein, the data compression apparatus 1 and the data decompression apparatus 2 each have hardware as a general computer and execute various kinds of processing by specifically using hardware 3 described below. The hardware 3 includes a processor 30, a storage device 31, an input interface circuit 32, an output interface circuit 33, and the like which are connected to one another via a bus 34.

The processor 30 is, for example, a single-core, dual-core, or multicore processor.

The storage device 31 is memory such as, for example, a read-only memory (ROM), a random-access memory (RAM), or semiconductor memory. The storage device 31 may include, for example, a hard disk drive, an optical disk device, and the like. The storage device 31 may implement the functions of the match position retaining sections 12, 22.

By using information stored in the storage device 31, the processor 30 may implement the functions of the match detecting section 11, the position comparing section 13, the retained position updating sections 14, 23, the encoding format selecting section 15, the encoding format information acquiring section 21, and the like. Similarly, the processor 30 and the storage device 31 may implement the functions of the encoding format information output section 16, the match length/position output section 17, the non-match length/sequence output section 18, the codes configuring section 19, the match length/position acquiring section 24, the non-match length acquiring section 25, and the like. Similarly, the processor 30 and the storage device 31 may also implement the functions of the non-match sequence output section 26, the match sequence output section 27, and the like.

The input interface circuit 32 is a circuit for receiving input of information from the outside. The input interface circuit 32 and the storage device 31 may implement the functions of the input buffer retaining sections 10, 20.

The output interface circuit 33 is a circuit for outputting information to the outside. The output interface circuit 33 and the storage device 31 may implement the functions of the output buffer retaining sections 19', 28.

The disclosure is not limited to what is described above, and all or part of the functional blocks illustrated in FIG. 3 or 5 may be appropriately implemented by dedicated hardware.

The data compression apparatus 1 according to the present embodiment is able to reduce the number of codes without decreasing the decompression speed, by selecting an encoding format based on a match position and encoding data with omission of the current match position if the current match position is the same as the immediately preceding match position, and by arranging codes in byte unit.

More specifically, when codes are arranged in byte unit using the data compression method according to the present embodiment, bit processing like the one performed in decompression of Huffman codes or the like may be omitted. The speed of reading data from a storage device such as a hard disk drive (HDD) is approximately 600 megabytes/second, whereas when the LZ77 method and Huffman coding are used, the decompression speed is approximately 300 megabytes/second. Thus, the speed of reading original data decreases. When the compression and decompression methods according to the present embodiment are used, the decompression speed is approximately 2,000 megabytes/second, which is approximately three times the reading speed for an HDD or the like and is therefore sufficiently high. Further, as to the number of codes, a match position in codes does not have to be allocated a fixed number of bytes like in the conventional LZ4 method, and the number of bytes to allocate is changed flexibly depending on the value of the match position. Accordingly, the number of codes may be reduced. For example, when the first four sets of sub-data (including the identification bits) of original data in FIG. 1 are encoded using the data compression method according to the present embodiment, the data is 19 bytes long as illustrated in the lower right part of FIG. 2. On the other hand, when the same data is encoded using the LZ4 method, the data is 24 bytes long. This way, the data compression method according to the present embodiment is able to reduce the number of codes, and thus allows, for example, a computer to have free space in the storage area or the like accordingly.

### Second Embodiment

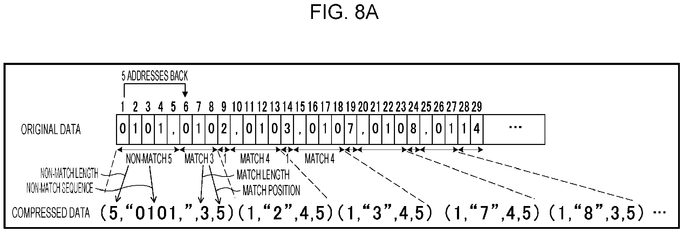

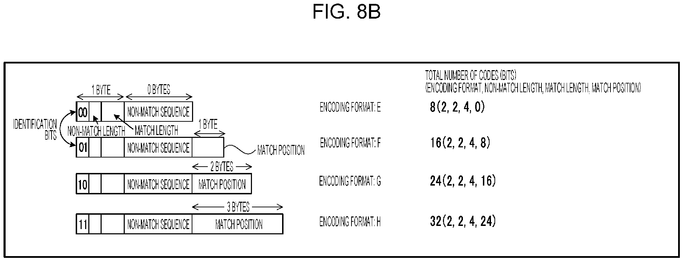

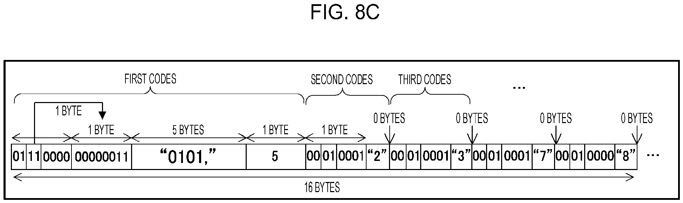

FIGs. 8A, 8B, and 8C are diagrams illustrating a data compression method according to a second embodiment. The functional blocks of a data compression apparatus and a data decompression apparatus according to the present embodiment are the same as those illustrated in FIGs. 3 and 5, and these functional blocks perform the same processing as those described in the first embodiment. For this reason, the apparatuses in the present embodiment are denoted by the same reference signs as those used in the first embodiment. Moreover, the procedures of the processing by the data compression apparatus and the data decompression apparatus are the same as those illustrated in FIGs. 4B and 6B. In the present embodiment, in place of the encoding formats used in the first embodiment (FIG. 2), encoding formats E, F, G, and H illustrated in FIG. 8B are used. To facilitate understanding, FIG. 8A illustrates compressed data obtained using the LZ77 method along with original data. The match positions and the like in this compressed data are the same as those illustrated in FIG. 2.

As illustrated in FIG. 8B, the present embodiment has four encoding formats E, F, G, and H. In the present embodiment, each set of identification bits is two bits long, and constitutes the first byte by being lumped with bits allocated to a non-match length and bits allocated to a match length.

Specifically, two bits are allocated to the non-match length, and four bits are allocated to the match length. When the non-match length of sub-data is larger than "10" in bit representation, another byte for the non-match length is added immediately after the byte allocated to the non-match length and the match length. Note that when the two bits allocated to the non-match length is "11", this indicates addition of another byte. Similarly, "1111" for the match length indicates addition of another byte.

Also, the same approach as that used in the first embodiment is used for a match sequence with a match length of three bytes or more in the original data.

The numbers of bytes allocated to a match position in the encoding formats E, F, G, and H are the same as those in the encoding formats A, B, C, and D. For example, when the match position in the current sub-data is the same as the match position in the immediately preceding sub-data, the encoding format E is selected to allocate 0 bytes to the match position. When the match position in sub-data is 2⁸ or more but less than 2¹⁶, the encoding format G is selected to allocate two bytes to the match position. In the encoding format E, the total number of bits in each compressed sub-data, including the identification bits and excluding the bits allocated to a non-match sequence, is for example 8 bits (2 (identification bits) +2 (non-match length) +4 (match length) +0 (match position)=8). Similarly, the total number of bits is 16 in the encoding format F, 24 in the encoding format G, and 32 in the encoding format H.

FIG. 8C illustrates an example of compressed data obtained when original data depicted in FIG. 8A is encoded using the encoding formats of the present embodiment. In FIGs. 8A, 8B, and 8C, n-th codes are the encoded n-th sub-data having identification bits added thereto. As to the first sub-data from the left of the data, a match position is 5, which is representable with one byte, and there is no preceding sub-data and hence no immediately-preceding match position. Based on this, the encoding format F is selected for the compression of this sub-data. Thus, the identification bits at the beginning of the compressed data in FIG. 8C are "01". Further, since the first sub-data has a non-match length of 5, which is "11" or more when represented with two bits, another byte is added to the first one byte as indicated with an arrow in the data illustrated in FIG. 8C. In this case, the non-match length is represented by the sum of "10", which is the maximum value representable with two bits, and a number represented by the additional byte.

Since a match length in the first sub-data is 3, the four bits allocated to the match length is "0000". Further, since the non-match sequence in the first sub-data is "0101,", which includes five characters, five bytes are allocated to the non-match sequence in the first code, with one byte allocated to each character. Further, since a match position in the first sub-data is 5, which is representable with one byte, one byte is allocated to the match position in the first codes. The same approach is used for the second sub-data and so on.

Unlike the first embodiment, the encoding of the present embodiment does not perform processing to wait until the encoding format information of each of four sets of compressed sub-data is encoded and lump these together. Thus, processing load decreases, and data compression time shortens. Since more bits are allocated to a match length than those in the first embodiment, the present embodiment is able to reduce the number of codes when the data to be encoded has the same partial sequence repeatedly and frequently.

### Third Embodiment

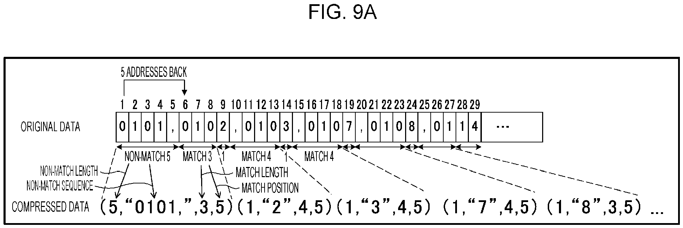

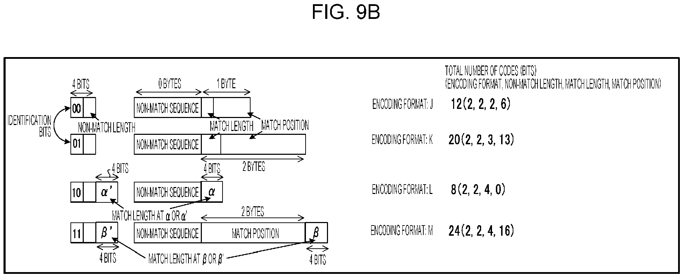

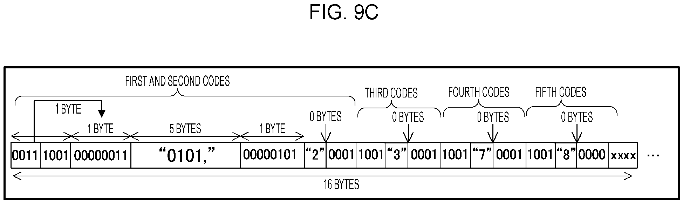

FIGs. 9A, 9B, and 9C are diagrams illustrating a data compression method according to a third embodiment. The functional blocks of a data compression apparatus and a data decompression apparatus according to the present embodiment are the same as those illustrated in FIGs. 3 and 5, and these functional blocks perform the same processing as those described in the first and second embodiments. For this reason, the apparatuses in the present embodiment are denoted by the same reference signs as those used in the first embodiment. Moreover, the procedures of the processing by the data compression apparatus and the data decompression apparatus are also the same as those illustrated in FIGs. 4B and 6B. In the present embodiment, in place of the encoding formats used in the first and second embodiments (FIGs. 2 and 8B), encoding formats J, K, L, and M illustrated in FIG. 9B are used. To facilitate understanding, FIG. 9A illustrates compressed data obtained using the LZ77 method along with original data. The match positions and the like in this compressed data are the same as those illustrated in FIG. 2.

As illustrated in FIG. 9B, the present embodiment has four encoding formats J, K, L, and M. In the present embodiment, two bits are allocated to identification bits and to a non-match length, and these total four bits are prepended to each set of codes. When the non-match length in sub-data is "11" or more in bit representation, another byte for the non-match length is added immediately after the byte including the two bits allocated to the non-match length.

The encoding format J is selected when the match position is a number from 0 to 2⁶-1 and is representable with six bits. In this encoding format, two bits are allocated to the match length, and the bits allocated to the match length and the bits allocated to the match position are lumped into one byte. Like in the above embodiments, the match length is at least 3, and the match length in bit representation is a bit representation of a number obtained by subtraction of 3 from the actual value of the match length. When a match length is not representable with two bits, namely with "10" or less, another byte is added for the match length, and this byte is added after the last bit of the match position. When the two bits allocated to the match length is "11", this indicates addition of another byte. In the encoding format J, the total number of bits excluding the bits allocated to a non-match sequence is 12 bits (2

(identification bits) +2 (non-match length) +2 (match length) +6 (match position) =12).

The encoding format K is selected when the match position is a number from 2⁶ to 2¹³-1 and is representable with 13 bits. In the encoding format K, three bits are allocated to the match length, and the bits allocated to the match length and the bits allocated to the match position are lumped into two bytes. In the same manner described above, the match length in bit representation is a bit representation of a number obtained by subtraction of 3 from the actual value of the match length. When the match length is not representable with three bits, as described above, another byte is added for the match length, and this byte is attached to the last bit of the match position. In the encoding format K, the total number of bits excluding the bits allocated to a non-match sequence is 20 bits (2 (identification bits) +2 (non-match length)+3 (match length) +13 (match position) =20).

The encoding format L is selected for encoding of sub-data whose match position is the same as the immediately preceding match position. Like in the above embodiments, the sub-data is encoded with omission of the match position. In the encoding format L, four bits are allocated to the match length and placed either immediately after the above-described bits allocated to the non-match sequence (the position indicated with α in FIG. 9B) or immediately after the preceding four bits for the "identification bit and non-match length" (the position indicated with α' in FIG. 9B). When the match length is not representable with four bits, another byte for the match length is added after that, in the same manner described above. In this encoding format, 0 bytes are allocated to the match position like in the above embodiments. In the encoding format L, the total number of bits excluding the bits allocated to a non-match sequence is 8 bits (2 (identification bits) +2 (non-match length) +4 (match length) +0 (match position) =8).

The encoding format M is selected when the match position is a number from 2¹³ to 2¹⁶-1 and is representable with 16 bits. In this format, two bytes are allocated to the match position. In this format, like in the encoding format L, four bits are allocated to the match length and placed either immediately after the two bytes allocated to the match position (the position indicated with β in FIG. 9B) or immediately after the preceding four bits for the "identification bit and non-match length" (the position indicated with β' in FIG. 9B). When the match length is not representable with four bits, another byte for the match length is added after that like in the encoding format L. In the encoding format M, the total number of bits excluding the bits allocated to a non-match sequence is 24 bits (2 (identification bits) +2 (non-match length) +4 (match length) +16 (match position) =24).

FIG. 9C illustrates an example of compressed data obtained when the original data illustrated in FIG. 9A is encoded using the encoding formats of the present embodiment. Like in the second embodiment, n-th codes are the encoded n-th sub-data having identification bits added thereto. However, in the encoding of the present embodiment, when one set of sub-data is to be handled as one set of codes, these codes may not be able to be arranged in byte unit. To deal with this, the data compression apparatus 1 of the present embodiment may generate codes in which match lengths, non-match sequences, and the like of two sets of sub-data are combined together. Such codes are the "first and second codes" illustrated in FIG. 9C. A description is given of the first and second codes.

First, since the match position in the first sub-data in the original data in FIG. 9A is 5, the encoding format J is selected to encode the first sub-data. Then, in the compressed data in FIG. 9C, the bits indicating the encoding format of the first sub-data is the first two bits "00". Next, since the non-match length in this sub-data is 5, which is "10" or more in bit representation, another byte is added. Thus, the non-match length is expressed by the sum of two bits "10" (=2) and one byte "00000011" (=3). In FIGs. 9A, 9B, and 9C, the byte added to the two bits originally allocated to the non-match length is indicated with the right end of an arrow extending from the original two bits, like in the second embodiment.

The compressed data in FIG. 9C includes four bits between the two bits allocated to the first non-match length and the additional byte. The sum of the identification bits for the encoding of the first sub-data and the two bits allocated to the non-match length in the first sub-data is four bits, which is not in byte unit. Thus, in the present embodiment, additional four bits are attached to these four bits, the additional four bits being the identification bits for the second sub-data and two bits allocated to the non-match length in the second sub-data.

In the second sub-data, the match position is 5, which is the same as that of the first sub-data. Thus, the encoding format L is selected to encode the second sub-data. The identification bits for the second sub-data is therefore "10". Further, since the non-match length of the second sub-data is "1", the two bits allocated to the non-match length is "01".

The non-match sequence in the first sub-data is placed after the two bits allocated to the non-match length of the second sub-data. Since the non-match sequence in the first sub-data is "0101,", which is a sequence of five numbers, five bytes are allocated to the non-match sequence. Next, since the match length of the first sub-data is 3, the two bits allocated to the match length is "00" in the encoding format J. In the encoding format J, the match position and the match sequence are lumped into one byte, and therefore the six bits for the first match position, which is 5, after the two bits for the match length is "000101" in bit representation.

Since the bits allocated to the first sub-data, the identification bits for the first sub-data, the non-match length of the second sub-data, and the identification bits for the second sub-data are already there, the next bits are those allocated for the non-match sequence of the second sub-data, which is "2". In the encoding format L, the sub-data is encoded with omission of the match position, and further, a bit representation of the match length follows the bit representation of the non-match sequence. Since the match length of the second sub-data is 4, a bit representation of 1 (=4-3) "0001" follows the bits allocated to the non-match sequence.

To make the encoded data be in byte unit, after the four bits "0001" representing the second match length, a total of four bits including the identification bits for the third sub-data and the bits for the non-match length of the third sub-data are attached. Since the match sequence in the third sub-data is the same as that in the second sub-data, the encoding format L is selected to encode the third sub-data. The identification bits are therefore "10". Further, since the non-match length in the third sub-data is 1, a bit representation of the non-match length is "01". The bits allocated to the non-match length are followed by a byte allocated to the non-match sequence, 3. This byte is then followed by bits "0001" allocated to the match length in the third sub-data, which is 4.

The same approach is used for the rest of the compressed data. The data compression method according to the present embodiment focuses on the fact that the match position is often representable with two bytes or less in actual data. Based on this, in the present embodiment, two bytes or less are allocated to the match position. Accordingly, bits are arranged flexibly in byte unit. Thereby, the number of codes in the present embodiment is smaller than that in the above embodiments.

The embodiments of the present disclosure are variously modifiable without departing from the spirit and scope of the present disclosure. Further, the embodiments described above are intended not to limit the scope of the present disclosure, but to illustrate the present disclosure. The present disclosure encompasses various modifications made within the scope of claims and within the scope and meaning of an equivalent of the disclosure.

## Claims

1. An apparatus comprising:
a processor that
detects a match sequence that matches with a preceding partial sequence in input data, a relative position of the match sequence with respect to the partial sequence, and a match length which is a length of the match sequence;
retains the relative position encoded lastly;
selects one of a plurality of encoding formats based on closeness indicated by the relative position, the encoding formats being set such that the number of bits to be allocated to the relative position varies among the encoding formats; and
encodes the input data by arranging codes in byte unit and omitting, depending on the encoding format selected, the relative position when the relative position is the same as the relative position encoded lastly and retained by the processor.

2. The apparatus of claim 1, wherein
the number of bits allocated to the relative position in accordance with the encoding formats becomes smaller as the relative position indicates a closer position.

3. The apparatus of claim 1 or 2, wherein
encoding format information is used to identify the encoding format selected.

4. The apparatus of claim 3, wherein
the processor encodes the encoding format information with a fixed number of bits in each of the plurality of encoding formats, and prepends the encoded encoding format information to data including at least one encoded match length.

5. The apparatus of claim 3 or 4, wherein
the processor encodes the encoding format information with two bits in each of the plurality of encoding formats, and
the processor lumps together pieces of the encoding format information corresponding to the respective encoding formats used for compression of four sets of data, and prepends the lumped pieces of encoding format information to the four sets of data compressed.

6. The apparatus of claim 3 or 4, wherein
the processor encodes the encoding format information with a fixed number of bits in each of the plurality of encoding formats, and
for every encoding of data including one match length, the processor prepends the encoded encoding format information corresponding to the encoding format used for the encoding to the encoded data including one match length.

7. The apparatus of any one of claims 1 to 6, wherein
a less number of bits are allocated for encoding of a non-match length, which is a length of a non-match sequence in the input data, the non-match sequence matching with no preceding partial sequence.

8. The apparatus of any one of claims 1 to 7, wherein
when the relative position is encoded without being omitted, the number of bytes allocated to the relative position is two bytes or less.

9. A data decompression apparatus that decompresses either codes encoded based on an encoding format selected according to closeness indicated by a relative position of a match sequence with respect to a preceding partial sequence with which the match sequence matches, or codes encoded with omission of the relative position which is the same as the relative position encoded lastly, the apparatus comprising:
a processor that
acquires, from input codes, encoding format information to identify an encoding format used for generation of the codes;
retains the relative position decompressed lastly; and
selectively uses the relative position based on the encoding format information in such a manner that the relative position decompressed lastly and retained by the processor is used for decompression of the codes encoded with omission of the relative position, and that the encoded relative position included in the codes is used for decompression of the codes encoded without omission of the relative position.

10. A method executed by a processor, comprising:
detecting a match sequence that matches with a preceding partial sequence in input data, a relative position of the match sequence with respect to the partial sequence, and a match length which is a length of the match sequence;
retaining the relative position encoded lastly;
selecting one of a plurality of encoding formats based on closeness indicated by the relative position, the encoding formats being set such that the number of bits to be allocated to the relative position varies among the encoding formats; and
encoding the input data by arranging codes in byte unit and omitting, depending on the encoding format selected, the relative position when the relative position is the same as the relative position encoded lastly and retained by the processor.

11. A program which, when executed on the computer, causes the computer to execute the method of claim 10.
